# EUROPÄISCHE PATENTSCHRIFT

(11) **EP 1 054 432 B1**
(45) Veröffentlichungstag und Bekanntmachung des Hinweises auf die Patenterteilung: **02.08.2006**
(21) Anmeldenummer: 99109667.8
(22) Anmeldetag: 16.05.1999
(51) Int. Cl.: H01J 37/32

(54) **Vorrichtung zur Plasmapolymerisation von Hohlkörperchargen in Mehrstückbearbeitung**
Device for plasma polymerizing batches of hollow workpieces in plural pieces processing
Dispositif pour la polymérisation par plasma de chargements de pièces creuses en traitement de pièces multiples

(43) Veröffentlichungstag der Anmeldung: 22.11.2000
(73) Patentinhaber: INPRO Innovationsgesellschaft für fortgeschrittene Produktionssysteme in der Fahrzeugindustrie mbH, 10587 Berlin (DE)
(72) Erfinder: Gleich, Henning, 47259 Duisburg (DE); Heckel, Horst, 64331 Weiterstadt (DE); Hoyer, Olaf, 16727 Schwante (DE); Kempen, Thomas, 12043 Berlin (DE); Steinhardt, Ingolf, 10585 Berlin (DE)
(74) Vertreter: Hoffmann, Klaus-Dieter

(56) Entgegenhaltungen:
- EP-A- 0 778 089
- WO-A-90/02213
- WO-A-97/47022
- DE-A- 1 690 663
- DE-A- 19 700 426

## Beschreibung

Die Erfindung betrifft eine Vorrichtung zur Plasmapolymerisation von Hohlkörperchargen in Mehrstückbearbeitung, mit mindestens einer mindestens eine Tür aufweisneden Reaktorkammer und dieser zugeordneten regelbaren Mikrowellen-Anregungsquellen, mit mit den Hohlkörpern bestückten und in die Reaktorkammer jeweils einführbaren Gestellen und mit mindestens einer Transporteinrichtung, die die mit den Hohlkörpern für die Plasmabehandlung bestückten Gestelle zur und von der Reaktorkammer befördert.

Die Plasmabehandlung von z.B. Hohlkörperchargen mit einem elektrodenfreien Energieeintrag mittels Mikrowelle bietet durch eine verhältnismäßig leichte Handhabung wirtschaftliche und prozeßtechnische Vorteile, da störende Elektroden in der Form von Sonden, Platten oder Helixwendeln (Spulen) induktiver oder kapazitiver Art, die bei entsprechend gebauten Vorrichtungen zur Plasmapolymerisation der Hohkkörpergeometrie angepaßt oder für die Plasmabehandlung in den Hohlkörper eingeführt werden müssen, nicht erforderlich sind. Derartige Anpassungen und Handhabungsschritte erübrigen sich bei einem mikrowellenangeregten Plasmaprozeß.

Bei einer bekannten Vorrichtung der eingangs erwähnten Art (EP 0 778 089 Al) ist die Reaktortür scharniermäfüg an der starren Reaktorkammer auf- und zuschwenkbar befestigt und die Transporteinrichtung ist ein Beschickungswagen, auf dem Holhlkörper wie z.B. Tanks in die und aus der Reaktorkammer ein- bzw, ausgefahren werden.

Angestrebt wird eine Vorrichtung zur Plasmapolymerisation der eingangs genannten Art, deren Reaktorkammer für unterschiedliche Stückzahlen und Hohlkörpergeometrien variable nutzbar ist. Hierzu sind im wesentlichen folgende Anforderungen zu erfüllen: eine variable Bestückbarkeit der Reaktorkammer, eine variable Reaktorgröße, ein von der Hohlkörpergeometrie unabhängiges Verfahren der Plasmapolymerisation und ein optimierter Energieeintrag durch eine variable Anordnung regelbarer Mikrowellen-Anregungsquellen am Reaktor.

Aus der Praxis sind nach dem Prinzip einer Frontlade- oder Durchlaufanlage ausgelegte Vorrichtungen ähnlich der eingangs erwähnten Art zur Entfettung von großflächigen Metallteilen mittels Plasmabehandlung bekannt, bei denen an der starren Reaktorkammer die Reaktorkammertür auf- und zuschiebbar angebracht ist und ein die zu bearbeitenden Metallteile aufnehmendes Gestell von einer Transporteinrichtung in die und aus der Reaktorkammer ein- bzw. ausgefahren wird.

Bekannt ist auch ein Konzept zur Bildung einer Reaktorkammer für die Plasmabehandlung hochentwickelter Produkte (Aurion Anlagentechnik GmbH, 1998), nach dem an einem starren würfelförmigen Kammerrahmen sechs Metallplatten aus Edelstahl oder Aluminium als Module für verschiedene Funktionen auswechselbar angebracht werden. So kann z.B. bei einem Reaktor mit unveränderbarem Volumen der Reaktorkammer zwischen verschiedenen Plasmaquellen (DV, MF, HF oder MW), unterschiedlichen Steuerungen, Pumpen usw. durch Austausch der entsprechend zugeordneten Metallplatte am starren Rahmen der Reaktorkammer gewählt werden.

Der Erfindung liegt die Aufgabe zugrunde, eine Vorrichtung der eingangs erwähnten Art zur Verfügung zu stellen, die eine variable Nutzung der Reaktorkammer für unterschiedliche Stückzahlen und Hohlkörpergeometrien bei optimierter Energieeinbringung durch die regelbaren MW-Anregungsquellen zur Plasmapolymerisation der Hohlkörperchargen ermöglicht.

Diese Aufgabe wird erfindungsgemäß dadurch gelöst, daß
- mittels einer Fixierung eins der mit den Hohlkörpern bestückten Gestelle an der mindestens einen Tür der Reaktorkammer lösbar fixiert ist,
- eine Einrichtung vorgesehen ist, mit der die mindestens eine Tür und das Gehäuse der Reaktorkammer ohne Scharniere zur vollständigen Entkopplung bzw. Kopplung miteinander relativ gegeneinander zu bewegen sind und ein Gesamtsystem, bestehend aus der Reaktortür und dem auf dieser fixierten, mit den Hohlkörpern bestückten Gestell, in die Bewegungsbahn der mindestens einen Transporteinrichtung zu integrieren ist,
- mittels einer Reaktorfixierung während der Plasmabehandlung das Gesamtsystem abdichtend lösbar am Gehäuse der Reaktorkammer befestigt und mit diesem gekoppelt ist, und
- die Anordnung der MV-Anregungsquellen an der Reaktorkammer variable ist.

Vorteilhafte Weiterbildungen der erfindungsgemäJien Vorrichtung sind in den Patentansprüchen 2 und 3 beschrieben.

Die erfindungsgemäße Vorrichtung kann nach dem Prinzip der Frontlaufanlage, nach dem Prinzip einer linearen Durchlaufanlage mit einer Schleuse und zwei zueinander parallel verlaufenden Transportbändern oder nach dem Prinzip einer kreisförmigen Durchlaufanlage mit einer Vielzahl Reaktorkammern ausgelegt sein.

Die veränderbare Ausbildung des mit der Reaktortür lösbar verbundenen Gestells des Gesamtsystems derart, daß der Reaktorraum als Variokammer im Bedarfsfall, z.B. bei geringerer Anzahl von Hohlköpern pro Beschichtungszyklus oder bei einer anderen Tankgeometrie volumenmäßig reduziert werden kann, so daß ein reduziertes Totvolumen (Volumen Reaktorkammer minus Summe der Volumina der Hohlkörper) gegeben ist, sorgt für eine effektive und-wirtschafffiche, von der Hohlkörpergeometrie unabhängige Plasmabehandhmg, Die variable Anbringung der MW-Anregungsquellen gewährleistet zudem einen optimierten Energieeintrag in die Reaktorkammer.

Bevorzugte Ausführungsformen der erfindungsgemäßen Vorrichtung und deren Einsatzmöglichkeiten werden nun anhand der Zeichnungen erläutert. In diesen sind:
**Fig**. **1** eine schematische Perspektivdarstellung einer Ausftihrunggform der Vorrichtung mit an der Reaktortür lösbar fixiertem Gestell,
**Fig. 2** eine schematische Perspektivdarstellung einer anderen Ausführungsfbnn der Vorrichtung mit an der Reaktortür lösbar angebrachtem, variablem Gestell zur Anpassung des Volumens bzw. der Innenkontur des Reaktorraums an die Anzahl der Hohlkörper pro Beschichtungszyklus,
**Fig. 3** eine schematische Perspektivdarstellung, die den Einsatz der Vorrichtung nach dem Prinzip einer Frontlaufanlage zeigt,
**Fig. 4** eine schematische Perspektivdarstellung, die den Einsatz der Vorrichtung nach dem Prinzip einer linearen Durchlaufanlage zeigt und
**Fig. 5** eine schematische Teilperspektivdarstellung, die den Einsatz der Vorrichtung nach dem Prinzip einer kreisförmigen Durchlaufanlage zeigt.

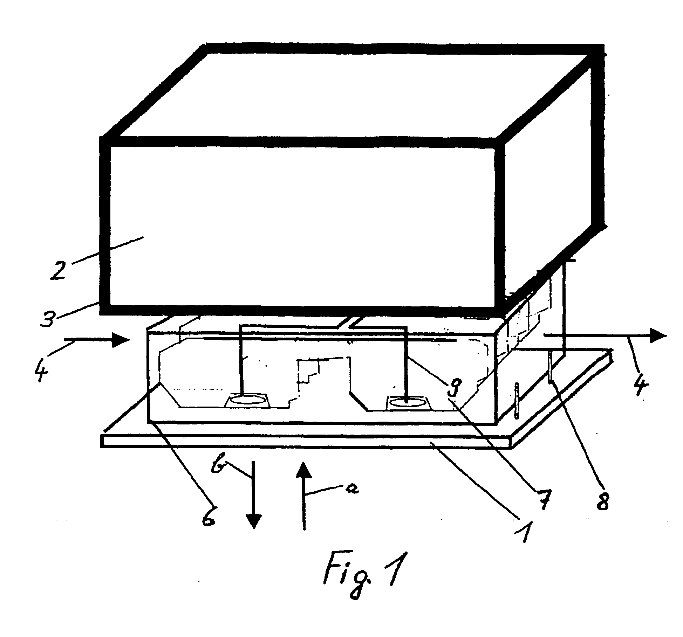

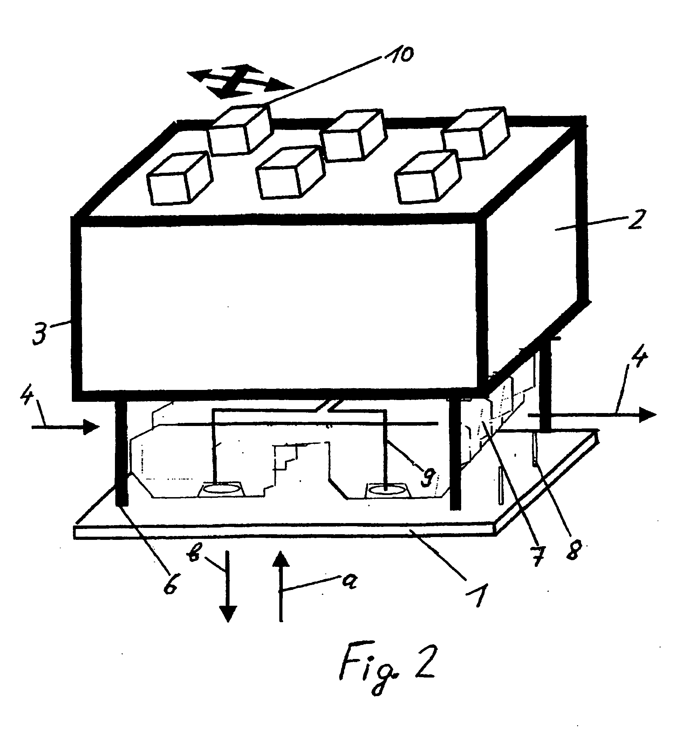

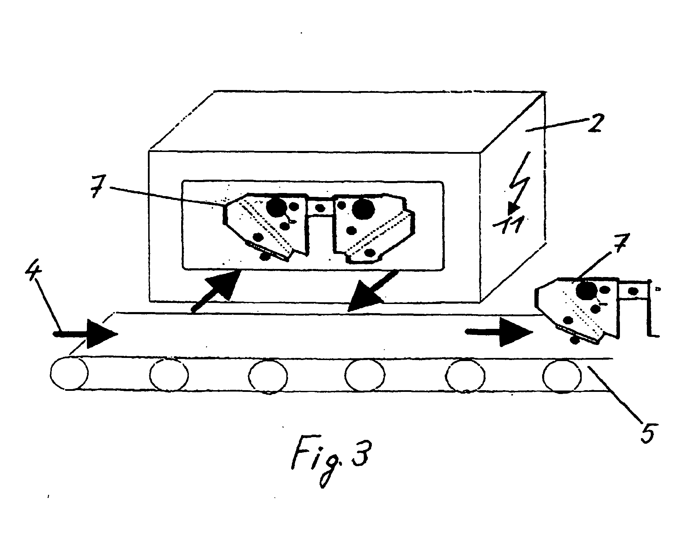

Wie aus den Fig. 1 und 2 hervorgeht, ist die Reaktortür 1 der Reaktorkammer 2 vollständig von deren Gehäuse 3 ohne Scharniere entkoppelt und in die Bewegungsbahn 4 einer Transporteinrichtung 5 in Form eines Transportbandes (Fig. 3 bis 5) integriert. An der Reaktortür 1 ist ein Gestell 6 mittels einer Fixierung lösbar angebracht, welches die Hohlkörper 7 für die Plasmabehandlung in der Vorrichtung aufnimmt. Zu diesem Zweck wird das mit den Hohlkörpern 7 bestückte Gestell 6 nach seiner Fixierung an der Reaktortür 1 zusammen mit letzterer in die Reaktorkammer 2 gefahren (Pfeil a) und das Gesamtsystem, bestehend aus der Reaktvrtür 1 und dem auf dieser fixierten, mit den Hohlkörpern 7 bestückten Gestell 6, am Gehäuse 3 der Reaktorkammer 2 mittels einer Reaktortürfixierung 8 abdichtend befestigt, worauf über eine Gaszuführung 9 die für die Plasmabehandlung der Hohlkörper 7 erforderliche Gaszufuhr in die Reaktorkammer 2 erfolgt. Nach Beendigung der Plasmabeschichtung und erfolgter Belüftung der Reaktorkammer 2 wird das Gesamtsystem, bestehend aus der Reaktortür 1 und dem auf dieser fixierten, mit den nunmehr beschichteten Hohlkörpern 7 bestückten Gestell 6, aus der Reaktortürfixierung 8 gelöst und aus der Reaktorkammer 2 heraus in die Bewegungsbahn 4 der Transporteinrichtung 5 gefahren. In Fig. 1 wird durch den Pfeil b angezeigt, daß in Abänderung der zuvor beschriebenen Ausführungsfbrm der Vorrichtung das Gehäuse 3 der Reaktorkammer 2 auch zur scharnierlosen Kopplung bzw. Entkopplung mit bzw. von der Reaktortür 2 des Gesamtsystems mittels einer Einrichtung auf die Reaktortür 2 des Gesamtsystems abgesenkt bzw. von dieser abgehoben werden kann.

Fig. 2 verdeutlicht eine andere Ausführungsfbrm der Vorrichtung, bei der das auf der Reaktortür 1 lösbar fixierte und mit den Hohlkörpern 7 bestückte Gestell 6 des Gesamtsystems derart verstellbar ausgebildet ist, daß die Reaktorkammer 2 als Variokammer im Bedarfsfall vvlumenmäßig zu verändern ist. Aus Fig. 2 geht weiterhin eine umrüstbar Befestigung von variabel an dem Gehäuse 3 der Reaktorkammer 2 anbringbaren MW-Anregungsquellen 10 der Vorrichtung hervor.

Fig. 3 zeigt den Einsatz der Vorrichtung nach dem Prinzip einer gängigen Frontlaufärdage, bei der die in die Bewegungsbahn 4 des Transportbandes 5 integrierte Reaktortür 2 (hier nicht dargestellt), an der das mit den Hohlkörpern 7 bestückte Gestell 6 mittels einer Fixierung lösbar fixiert ist, von der Frontseite in die bzw. aus der Reaktorkammer 2 zur bzw. nach der Behandlung der Hohlkörper 7 mit dem Plasma 11 ein- bzw. ausgefahren wird.

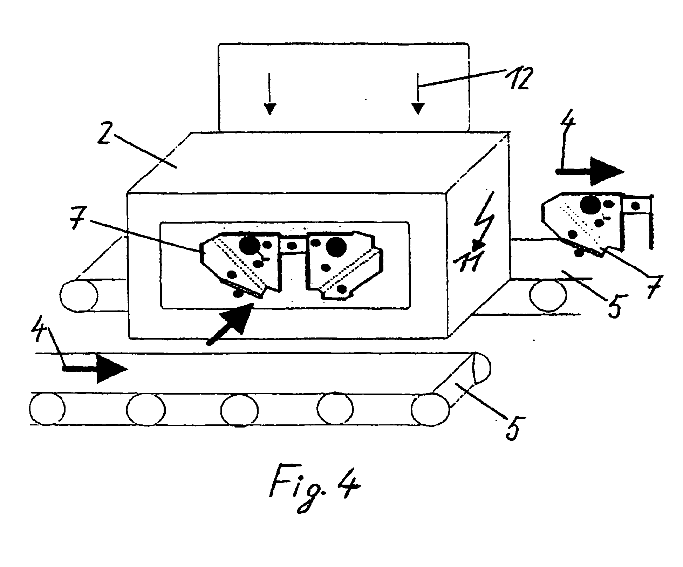

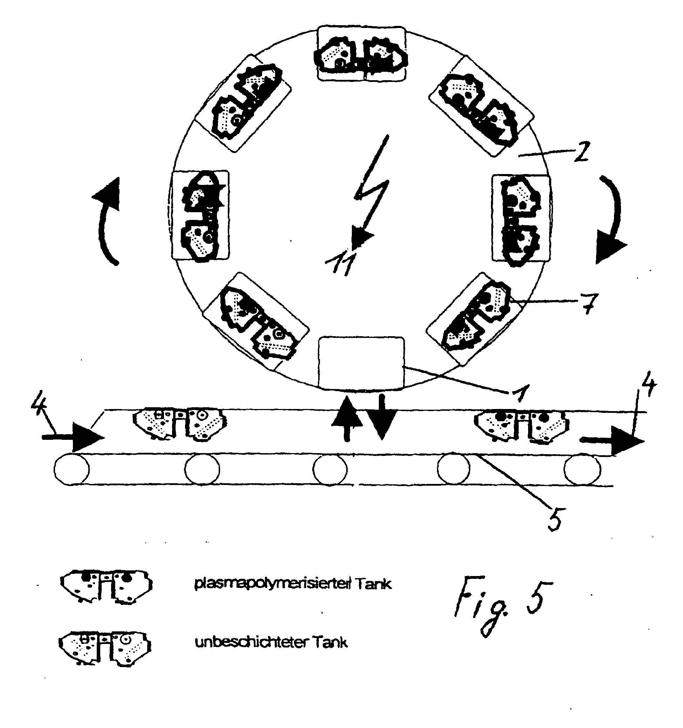

Aus Fig. 4 geht der Einsatz der Vorrichtung nach dem gängigen Prinzip einer linearen Durchlaufanlage mit zwei zueinander parallel verlaufenden Transportbändern 5 und einer Schleuse 12 für die Abführung der mit dem Plasma 11 behandelten Hohlkörper 7 hervor. Fig. 5 zeigt schließlich die Auslegung der Vorrichtung nach dem Prinzip einer kreisförmigen Durchlaufanlage mit einer Vielzahl als Paletten ausgeführter, jeweils mit einem lösbar fixierten Gestell 6 versehener Reaktortüren 1, die in die Bewegungsbahn 4 des Transportbandes 5 integrierbar sind.

## Patentansprüche

1. Vorrichtung zur Plasmapolymerisation von Hohlkörper-Chargen in Mehrstückbearbeitung mit mindestens einer mindestens eine Tür (1) aufweisenden Reaktorkammer(2) und dieser zugeordneten regelbaren Mikrowellen-Anregungsquellen(9), mit mit den Hohlkörpern (7) bestückten und in die Reaktorkammer (2) jeweils eizahrbaren Gestellen (6) und mit mindestens einer Transporteinrichtung, (5), die die mit den Hohlkörpern (7) für die Plasmabehandlung bestückten Gestelle (6) zur und von der Reaktorkammer (2) befördert, **dadurch gekennzeichnet, daß**
- mittels einer Fixierung eins der mit den Hohlkörpern (7) bestückten Gestelle (6) an der mindestens einen Tür (1) der Reaktorkammer (2) lösbar fixiert ist,
- eine Einrichtung vorgesehen ist, mit der die mindestens eine Tür (1) und das Gehäuse (3) der Reaktorkammer (2) ohne Scharniere zur vollständigen Entkopplung bzw. Kopplung miteinander relativ gegeneinander zu bewegen sind und ein Gesamtsystem, bestehend aus der Reaktortür (1) und dem auf dieser fixierten, mit den Hohlkörpern (7) bestückten Gestell (6), in die Bewegungsbahn der mindestens einen Transporteinrichtung (5) zu integrieren ist,
- mittels einer Reaktortürfucierung (8) während der Plasmabehandlung das Gesamtsystem abdichtend lösbar am Gehäuse (3) der Reaktorkammer (2) befestigt und mit diesem gekoppelt ist, und
- die Anordnung der MV-Anregungsquellen (9) an der Reaktorkammer (2) variabel ist.

2. Vorrichtung nach Anspruch 1, **dadurch gekennzeichnet, daß** das Gehäuse (3) der Reaktorkammer (2) bei in die Bewegungsbahn der mindestens einen Transporteinrichtung (5) integrierter Reaktortür (1) des Gesamtsystems zur vollständigen scharnierlosen Kopplung bzw. Entkopplung des Gehäuses (3) der Reaktorkammer (2) und der Reaktortür (1) des Gesamtsystems miteinander mittels einer Einrichtung auf die Reaktortür (1) des Gesamtsystems abzusenken bzw. von dieser abzuheben ist.

3. Vorrichtung nach Anspruch 1 oder 2, **dadurch gekennzeichnet, daß** das mit den Hohlkörpern (7) bestückte Gestell (6) des Gesamtsystems zu verstellen und somit der Reaktorraum der Reaktorkammer (2) bei Einsetzen der Reaktortür (1) des Gesamtsystems in die Reaktorkammer (2) volumen- und/oder konturenmäßig zu verändern ist.

## Claims

1. A device for plasma polymerisation of batches of hollow workpieces in plural-piece processing using at least one reactor chamber (2) having at least one door (1) and controllable microwave excitation sources (9) allocated thereto, comprising frames (6) which are equipped with the hollow workpieces (7) and which can each be inserted into the reactor chamber (2), and comprising at least one transport device (5) which conveys the frames (6) equipped with the hollow workpieces (7) for the plasma treatment to and from the reactor chamber (2), **characterised in that**
- one of the frames (6) equipped with the hollow workpieces (7) is detachably fixed to the at least one door (1) of the reactor chamber (2) by means of a fixing,
- a device is provided by which means the at least one door (1) and the housing (3) of the reactor chamber (2) can be moved relative to one another without hinges for complete decoupling or coupling with one another and a complete system consisting of the reactor door (1) and the frame (6) equipped with the hollow workpieces (7) which is affixed thereon, is to be integrated into the movement path of the at least one transport device (5),
- the complete system is detachably affixed to the housing (3) of the reactor chamber (2) in a sealed fashion during the plasma treatment by means of a reactor door fixing (8) and is coupled thereto, and
- the arrangement of the MW excitation sources (9) on the reactor chamber (2) is variable.

2. The device according to claim 1, **characterised in that** when the reactor door (1) of the complete system is integrated in the movement path of the at least one transport device (5), the housing (3) of the reactor chamber (2) can be lowered onto the reactor door (1) of the complete system or raised therefrom by means of a device for complete hingeless coupling or decoupling of the housing (3) of the reactor chamber (2) and the reactor door (1) of the complete system.

3. The device according to claim 1 or 2, **characterised in that** the frame (6) of the complete system equipped with the hollow workpieces (7) can be adjusted and thus the reactor space of the reactor chamber (2) can be varied in volume and/or contour when inserting the reactor door (1) of the complete system into the reactor chamber (2).

## Revendications

1. Dispositif pour la polymérisation plasma de charges de corps creux en usinage multi-pièces avec au moins une chambre de réacteur (2) comportant au moins une porte (1) et des sources d'excitation réglables par micro-ondes (9) qui lui sont associées, avec des châssis (6) équipés des corps creux (7) et pouvant être respectivement introduits dans la chambre de réacteur (2) et avec au moins un dispositif de transport (5) convoyant les châssis (6) équipés des corps creux (7) vers et à partir de la chambre de réacteur (2) pour le traitement plasma, **caractérisé en ce que**
- au moyen d'une fixation, l'un des châssis (6) équipés des corps creux (7) est fixé de façon amovible sur la au moins une porte (1) de la chambre de réacteur (2),
- on a prévu un système permettant de déplacer conjointement, sans charnières et l'un par rapport à l'autre la au moins une porte (1) et le carter (3) de la chambre de réacteur (2) pour le découplage ou le couplage complet et **en ce qu'**un système global composé de la porte du réacteur (1) et du châssis (6) fixé sur cette dernière, équipé des corps creux (7) doit être intégré dans la trajectoire de déplacement du au moins un dispositif de transport (5),
- pendant le traitement plasma, le système global est fixé de façon amovible et étanche sur le carter (3) de la chambre de réacteur (2) au moyen d'une fixation de porte de réacteur (8) et couplé à ce dernier, et
- la disposition des sources d'excitation aux MO (9) sur la chambre de réacteur (2) est variable.

2. Dispositif selon la revendication 1, **caractérisé en ce que** lorsque la porte du réacteur (1) du système global est intégrée dans la trajectoire de déplacement du au moins un dispositif de transport (5), le carter (3) de la chambre de réacteur (2) doit être abaissé ou relevé sur la porte de réacteur (1) du système global au moyen d'un dispositif, pour le couplage ou le découplage total sans charnière du carter (3) de la chambre de réacteur (2) et de la porte de réacteur (1) .

3. Dispositif selon la revendication 1 ou 2, **caractérisé en ce que** le châssis (6) du système global équipé des corps creux (7) doit être réglé et que de ce fait l'espace du réacteur dans la chambre de réacteur (2) doit être modifié au niveau de son volume et/ou de son contour, lors de l'insertion de la porte de réacteur (1) du système global dans la chambre de réacteur (2).
